(19) Europäisches Patentamt / European Patent Office / Office européen des brevets

(11) EP 2 388 815 A1

(12) EUROPEAN PATENT APPLICATION

(43) Date of publication:
23.11.2011 Bulletin 2011/47

(51) Int Cl.:
$H01L\ 23/64$ (2006.01)     $H01L\ 23/66$ (2006.01)
$H03F\ 1/56$ (2006.01)     $H01L\ 23/00$ (2006.01)

(21) Application number: 10162430.2

(22) Date of filing: 10.05.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: NXP B.V.
5656 AG Eindhoven (NL)

(72) Inventor: Heeres, Rob Mathijs
5656 AE Eindhoven (NL)

(74) Representative: Schouten, Marcus Maria
NXP B.V.
IP & Licensing Department
High Tech Campus 60
5656 AG Eindhoven (NL)

(54) **A transistor package**

(57) There is disclosed a transistor package (PK1; PK2; PK3), comprising a transistor (TR) with a transistor output (TO), and an output terminal (OT). The transistor output is connected to the output terminal (OT) via an output bondwire (Ld); and is also connected to a series arrangement of an inductor (Li1, Li2) and a capacitor (Cb). The inductor is for resonating with the capacitive output impedance of the transistor output, and the capacitor is for for blocking DC currents. The inductor is formed by first (Li1) and second (Li2) bondwires in series, the first bondwire (Li1) being placed to positively couple with the output bondwire (Ld; Ld1), and the second bondwire (Li2) being placed to negatively couple with the output bondwire (Ld; Ld1).

Fig. 3

## Description

The present invention relates to a transistor package, and more particularly to a transistor package including an inductance connected to the transistor output.

Fig.1 shows a diagram of a known transistor package PKp, such as that described in US 2002/0109203. The transistor package comprise an active die ADp, a passive die PDp, and an output terminal OTp. The active die ADp comprises one or more transistors TRp connected in parallel and a transistor output TOp. The transistor output TOp is connected to the output terminal OTp via two bondwires, Ld1p and Ld2p, that are interspaced by a post-matching capacitor Cpp.

To compensate for the parasitic output capacitance of the transistor output TOp, the transistor package further comprises an inductor formed by bondwire Lip, and connected to a DC blocking capacitor Cbp. The inductor Lip is sized to form a parallel resonant circuit with the parasitic capacitance of the transistor output TOp at the frequency of operation, e.g. 2GHz. This type of compensation circuit is commonly referred to as an INSHIN circuit, i.e. an INternal SHunt INductor circuit.

However, positive coupling due to the mutual inductance between the bondwires Ld1p and Lip, reduces the effective size of the inductance Lip. The size of Lip can be increased to compensate, although this typically requires additional space, and lowers the output impedance of the circuit.

The mutual inductance between two wires i and j is given by the double integral Neumann formula:

$$Mij = \frac{\mu 0}{4\Pi} \oint_{Ci} \oint_{Cj} \frac{dsi \bullet dsj}{|Rij|}$$

wherein Ci and Cj are the curves spanned by the wires, dsi and dsj are the vectors for each point along the wires, and Rij is the distance between the points. Hence, it can be seen that the closer together the wires are, and the larger the vector product between the two wires, the larger the mutual inductance and therefore the coupling will be. Prior art efforts to reduce the coupling between Lip and Ld1 p often focus on putting a large distance between Lip and Ld1 p (to increase Rij), or placing Lip and Ld1 p at right angles to one another (to reduce the vector product dsi.dsj).

According to an embodiment of the invention, there is provided a transistor package, comprising a transistor with a transistor output, and an output terminal, the transistor output:

- being connected to the output terminal via an output bondwire; and
- being connected to a series arrangement of an inductor and a capacitor, the inductor for resonating with the capacitive output impedance of the transistor output, and the capacitor for blocking DC currents; wherein the inductor is formed by first and second bondwires in series, the first bondwire being placed to positively couple with the output bondwire, and the second bondwire being placed to negatively couple with the output bondwire.

Since the second bondwire negatively couples with the output bondwire, it tends to cancel out much of the positive coupling that occurs between the first bondwire and the output bondwire, thereby improving the compensation of the output capacitance of the transistor. Consequently, the unwanted transformation of the output impedance to lower values (due to the positive coupling) may be reduced or even eliminated, resulting in a higher real load impedance and a lower loaded Q factor at the output terminal. This can help reduce the losses and increase the bandwidth of subsequent circuitry.

Furthermore, by cancelling out the coupling, the unwanted reduction in the effective inductance of the inductor may be reduced or even reversed. Therefore, the required level of inductance can be obtained by using a smaller-valued inductor. This means that the lengths of the bondwires forming the inductor can be shortened to ease the packaging of the transistor, whilst still providing the required level of inductance.

As will be explained further herein, the sign (positive or negative) of the coupling between two wires depends on the relative directions of the currents flowing through them. Positive coupling occurs when a current being driven through a first wire induces a current in a second wire that opposes an existing current being driven through the second wire, and negative coupling occurs when a current being driven through a first wire induces a current in a second wire that re-enforces an existing current being driven through the second wire.

The placement of the first and second bondwires determines whether the couplings to the output bondwire are positive or negative, since both the output bondwire and the first and second bondwires are driven by the same AC (alternating current) signal at transistor output TO.

Advantageously, the first, second, and output bondwires may be further placed so that the mutual inductance between the output bondwire and the second bondwire is higher than the mutual inductance between the output bondwire and the first bondwire. Then, the negative coupling between the second bondwire and the output bondwire more than cancels out the positive coupling between the first bondwire and the output bondwire, increasing the effective inductance of the inductor.

Embodiments of the invention will be apparent from and further elucidated by the following figures and examples, which are not intended to limit the scope of the invention. The person skilled in the art will understand that various embodiments may be combined.

Fig. 1 shows a schematic diagram of a known transistor package;

Fig. 2 shows a diagram of two wires coupled by a mutual inductance;

Fig. 3 shows a schematic diagram of a transistor package according to a first embodiment of the invention;

Fig. 4 shows a schematic diagram of a transistor package according to a second embodiment of the invention; and

Fig. 5 shows a schematic diagram of a transistor package according to a third embodiment of the invention.

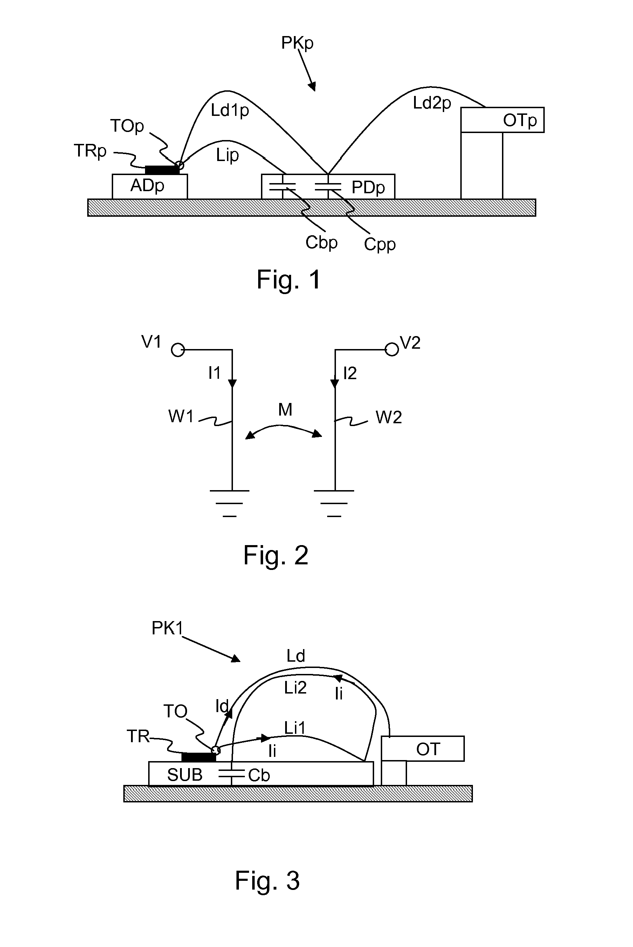

Fig.2 shows first and second wires W1 and W2. A voltage V1 is applied to W1, resulting in a current I1, and a voltage V2 is applied to W2, resulting in a current I2. The first and second wires W1 and W2 are coupled together by a mutual inductance M. Mathematically, the (inductive) impedance Z1 of the wire W1 is given by the following:

$$Z1 = j\omega L1 - j\omega M = j\omega L1 - j\omega V1/I2$$

wherein L1 is the self-inductance of the first wire W1.

Therefore, the inductive impedance Z1 of the first wire W1 reduces below $j\omega L1$ if the parallel adjacent wire W2 is driven with a current I2 that is in the same direction to a current I1 being driven in the first wire W1. This effect is referred to herein as positive coupling, i.e. coupling that tends to reduce the inductive impedance Z1 of the first wire W1.

Conversely, the inductive impedance Z1 of the first wire W1 effectively increases above $j\omega L1$ if the parallel adjacent wire W2 is driven with a current -I2 that is in the opposite direction to a current I1 being driven in the first wire W1. This effect is herein referred to as negative coupling, i.e. coupling that tends to increase the inductive impedance Z1 of the first wire W1.

Fig.3 shows a diagram of a transistor package PK1 according to a first embodiment of the invention. The transistor package comprises a substrate SUB having a transistor TR, a transistor output TO, and an output terminal OT. The transistor output TO is connected to an output bondwire Ld, and to a series arrangement of an inductor and a capacitor Cb for blocking DC currents. The inductor is formed by first and second bondwires Li1 and Li2, and is for resonating with the parasitic output capacitance of transistor output TO. There is a mutual inductance between the first bondwire Li1 and the output bondwire Ld, and another mutual inductance between the second bondwire Li2 and the output bondwire Ld.

When the transistor output TO raises its voltage, it drives an output current Id into the output bondwire and an output current Ii into the first and second bondwires. Then, positive coupling occurs between the output bondwire Ld and the first bondwire Li1 since the currents Id and Ii are flowing in similar directions (within 90° of one another), and negative coupling occurs between the output bondwire Ld and the second bondwire Li2 since the currents Id and Ii are flowing in dissimilar directions (greater than 90° from each other).

According to the term (dsi.dsj/Rij) in the earlier described Neumann formula, the mutual inductance between first bondwire Li1 and output bondwire Ld is relatively low because Li1 and Ld are relatively far apart from one another (i.e. Rij is high), and the mutual inductance between second bondwire Li2 and output bondwire Ld is relatively high because Li2 and Ld are relatively close together (i.e. Rij is low). Therefore, the negative coupling between the second and output bondwires can more than cancel out the positive coupling between the first and output bondwires.

In this embodiment, the DC blocking capacitor Cb is formed by a bondpad (not shown) on the substrate SUB and the ground plane GND. Alternately, it may be formed by a discrete capacitor component.

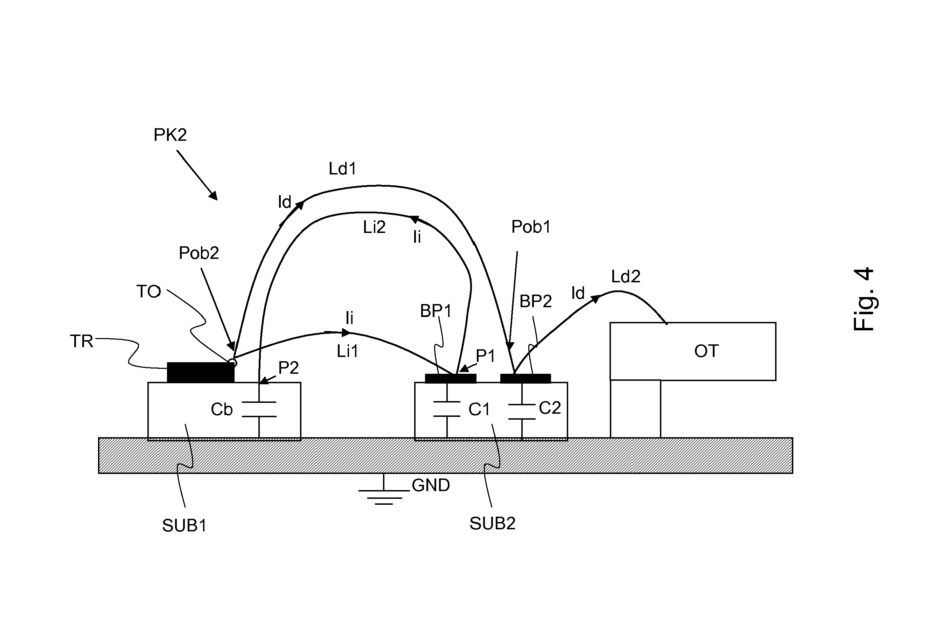

Fig.4 shows a diagram of a transistor package PK2 according to a second embodiment of the invention. Compared to the first embodiment, the second embodiment further comprises another substrate SUB2, which is used to form a capacitor C1 between a ground plate GND and a first bondpad BP1. The first bondpad BP1 interspaces (i.e. connects together) the first and second bondwires Li1 and Li2. The physical size of the first bondpad can be adjusted to adjust the size of the capacitance C1. The capacitance C1 enables 2nd harmonic tuning, to further improve the compensation of the parasitic output capacitance of the transistor output TO.

Compared to the first embodiment, the output bondwire Ld is now formed by two sub-bondwires Ld1 and Ld2, which are connected in series by a second bondpad BP2. The second bondpad BP2 is also on the substrate SUB2 and forms a capacitor C2 with the ground plane GND. The physical size of the second bondpad BP2 can be adjusted to adjust the size of the capacitance C2. The capacitance C2 enables low-pass filtering (matching) of the signal that is output to the output terminal OT.

As in the first embodiment, negative coupling between the bondwires Ld1 and Li2 helps compensate for the positive coupling that occurs between Ld1 and Li1.

The second bondwire Li2 is connected from a first point P1 to a second point P2. The point P1 is at the interface between the first bondwire Li1 and the second bondwire Li2. The point P1 is electrically closer to the transistor output TO than the point P2, in other words the electrical path from the transistor output TO to the point P1 is shorter than the electrical path from the transistor output TO to the second point P2. The point on the output bondwire Ld1 that is physically closest to the point P1 is the point Pob1, and the point on the output bondwire Ld1 that is physically closest to the point P2 is the point Pob2. The point Pob1 is electrically closer to the output terminal

OT than the point Pob2. Since the transistor output TO drives both the second bondwire Li2 (via first bondwire Li1) and the output bondwire Ld1, the arrangement of points described above requires that currents in bondwires Li2 and Ld1 will flow in dissimilar directions to one another when changing the transistor output voltage, giving negative coupling between them.

The output bondwire Ld1 is more closely aligned with the second bondwire Li2 than with the first bondwire Li1, giving a higher mutual inductance between Ld1 and Li2 than between Ld1 and Li1, and meaning that the negative coupling between Ld1 and Li2 more than cancels out the positive coupling between Ld1 and Li1.

The substrate SUB1 is an active die supporting the transistor TR and the substrate SUB2 is a passive die supporting the first BP1 and second BP2 bondpads. In other embodiments the substrates SUB1 and SUB2 may be formed as a single active die.

In this embodiment, the DC blocking capacitor Cb is formed on the active die SUB1, although it could also be formed separately from the active die. Forming the capacitor Cb on the active die means that there is only a short distance between the transistor TR and the capacitor Cb, reducing losses due to ground return currents.

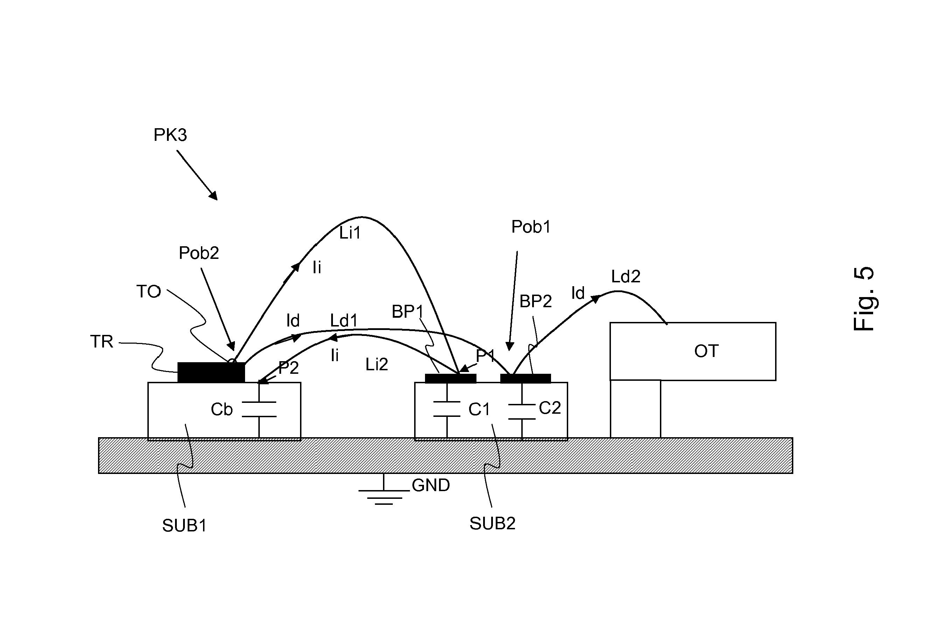

Fig. 5 shows a diagram of a transistor package PK3, in which the bondwire Li1 loops higher than the Li2 and Ld1 bondwires, instead of below them as in Fig.4. This results in a lower Ld1 inductance value, and therefore this configuration can be used in case no extra low-pass matching (formed by Ld1-C2) is required. Additionally, there is a space advantage because Li1 and Li2 can be assembled on top of each other in the same plane, thereby possibly increasing the density of parallel wires of Li1, Li2, and Ld1.

The Invention is defined by the appended claims, and further embodiments not explicitly described in the application intentionally fall within their scope. Reference signs do not limit the scope of the claims.

**Claims**

1.  A transistor package (PK1; PK2; PK3), comprising a transistor (TR) with a transistor output (TO), and an output terminal (OT), the transistor output:

    - being connected to the output terminal (OT) via an output bondwire (Ld; Ld1, Ld2); and
    - being connected to a series arrangement of an inductor (Li1, Li2) and a capacitor (Cb), the inductor for resonating with the capacitive output impedance of the transistor output, and the capacitor for blocking DC currents; wherein the inductor is formed by first (Li1) and second (Li2) bondwires in series, the first bondwire (Li1) being placed to positively couple with the output bondwire (Ld; Ld1), and the second bondwire (Li2) being placed to negatively couple with the output bondwire (Ld; Ld1).

2.  A transistor package according to claim 1, wherein the second bondwire (Li2) is connected from a first point (P1) to a second point (P2), the first point (P1) being at the interface between the first (Li1) and second (Li2) bondwires, and the first point (P1) being electrically closer to the transistor output (TO) than the second point (P2), and wherein the point (Pob1) on the output bondwire that is physically closest to the first point (P1) is electrically closer to the output terminal (OT) than the point on the output bondwire (Pob2) that is physically closest to the second point (P2), such that negative coupling will occur between the second bondwire (Li2) and the output bondwire (Ld1) when changing the transistor output voltage.

3.  A transistor package according to claims 1 or 2, wherein the first (Li1), second (Li2), and output (Ld; Ld1, Ld2) bondwires are further placed so that the mutual inductance between the output bondwire (Ld; Ld1) and the second bondwire (Li2) is higher than the mutual inductance between the output bondwire (Ld; Ld1) and the first bondwire (Li1).

4.  A transistor package according to claim 3, wherein the output bondwire (Ld; Ld1) is more closely aligned with the second bondwire (Li2) than with the first bondwire (Li1).

5.  A transistor package according to claims 1, 2, 3, or 4, wherein the first and second bondwires are interspaced by a first bondpad (BP1), the first bondpad holding the first and second bondwires in place.

6.  A transistor package according to claim 5, wherein the first bondpad (BP1) and a groundplate of the package together form a shunt capacitor (C1) for 2nd harmonic tuning.

7.  A transistor package according to any of claims 1 to 6, wherein the output bondwire (Ld) is formed by two sub-bondwires (Ld1, Ld2) connected in series, the series connection between them being made by a second bondpad (BP2), wherein the second bondpad and a groundplate of the package together form a shunt capacitor (C2) for low-pass filtering.

8.  A transistor package according to all of claims 1 to 7, wherein the package comprises an active die (SUB1) supporting the transistor, and a passive die (SUB2) supporting the first and the second bondpads.

9.  A transistor package according to any preceding claim, wherein the transistor (TR) and the capacitor (Cb) of the series arrangement are formed on the same die.

PKp

Ld1p                    Ld2p

TOp                                      OTp
TRp            Lip

ADp          ⊥   ⊥   PDp
              ⊤   ⊤

Cbp   Cpp

## Fig. 1

V1 ○              ○ V2

I1                 I2

W1        M        W2

## Fig. 2

PK1

Ld

Li2

TO    Id        Ii

TR         Li1

Ii

OT

SUB   ⊥ Cb
       ⊤

## Fig. 3

Fig. 4

Fig. 5

EP 2 388 815 A1

EUROPEAN SEARCH REPORT

Application Number

EP 10 16 2430

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/046031 A2 (KONINKL PHILIPS ELECTRONICS NV [NL]; HARM LEX [NL] NXP BV [NL]; HARM L) 26 April 2007 (2007-04-26) | 1,5,9 | INV.<br>H01L23/64<br>H01L23/66 |
| Y | * page 5, line 13 - line 22; figures 3,5,7 * <br>* page 5, line 32 - line 33 *<br>* page 6, line 29 - line 33 *<br>* page 7, line 10 - line 18 * | 3,4,7,8 | H03F1/56<br>H01L23/00 |
| X | EP 1 750 298 A2 (INFINEON TECHNOLOGIES AG [DE]) 7 February 2007 (2007-02-07) | 1,2,5,6 | |
| Y | * paragraph [0028] - paragraph [0030]; figures 1,2,3 *<br>* paragraph [0025] * | 3,4,7,8 | |
| Y | US 2009/096068 A1 (SJOESTROEM JOHAN [SE]) 16 April 2009 (2009-04-16)<br>* paragraph [0020] - paragraph [0024]; figures 1a-1c,2a-2c *<br>* paragraph [0030] * | 3,4 | |
| Y,D | US 2002/109203 A1 (ROODNAT ANTON WILLEM [NL]) 15 August 2002 (2002-08-15)<br>* paragraph [0014] - paragraph [0017]; figures 3,4 * | 7,8 | TECHNICAL FIELDS SEARCHED (IPC)<br><br>H01L<br>H03F |
| A | US 2004/061214 A1 (CRESCENZI EMIL JAMES [US] CRESCENZI JR EMIL JAMES [US]) 1 April 2004 (2004-04-01)<br>* paragraph [0019] - paragraph [0023]; figures 5A,5B,6A,6B,7A,7B,8A,8B * | 1-9 | |
| A | WO 03/081670 A1 (KONINKL PHILIPS ELECTRONICS NV [NL]; BLEDNOV IGOR I [NL]) 2 October 2003 (2003-10-02)<br>* page 1, line 10 - page 10, line 30; figures 1-6 * | 1-9 | |

-/--

The present search report has been drawn up for all claims

| Place of search | Date of completion of the search | Examiner |
|---|---|---|
| Munich | 12 October 2010 | Gospodinova, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

8

Europäisches
Patentamt
European
Patent Office
Office européen
des brevets

# EUROPEAN SEARCH REPORT

**Application Number**

EP 10 16 2430

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 03/065569 A2 (KONINKL PHILIPS ELECTRONICS NV [NL]; BLEDNOV IGOR I [NL]; VENNEMA ALLE) 7 August 2003 (2003-08-07) * page 5, line 30 - page 10, line 9; figures 1-3,9,10 * ----- | 1-9 | |
| A | WO 2006/016299 A1 (KONINKL PHILIPS ELECTRONICS NV [NL]; BLEDNOV IGOR [NL]) 16 February 2006 (2006-02-16) * figures 1-3,5,7A-7B,10B * ----- | 1-9 | |

TECHNICAL FIELDS
SEARCHED     (IPC)

The present search report has been drawn up for all claims

| Place of search | Date of completion of the search | Examiner |
|---|---|---|
| Munich | 12 October 2010 | Gospodinova, M |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 10 16 2430

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2010

| Patent document cited in search report | | Publication date | Patent family member(s) | | Publication date |
|---|---|---|---|---|---|
| WO 2007046031 | A2 | 26-04-2007 | CN | 101292349 A | 22-10-2008 |
| | | | JP | 2009512384 T | 19-03-2009 |
| | | | US | 2008278241 A1 | 13-11-2008 |
| EP 1750298 | A2 | 07-02-2007 | CN | 1976023 A | 06-06-2007 |
| | | | KR | 20070014076 A | 31-01-2007 |
| | | | US | 2007024374 A1 | 01-02-2007 |
| US 2009096068 | A1 | 16-04-2009 | NONE | | |
| US 2002109203 | A1 | 15-08-2002 | AT | 417361 T | 15-12-2008 |
| | | | EP | 1356521 A1 | 29-10-2003 |
| | | | WO | 02058149 A1 | 25-07-2002 |
| | | | JP | 4319407 B2 | 26-08-2009 |
| | | | JP | 2004523111 T | 29-07-2004 |
| US 2004061214 | A1 | 01-04-2004 | AU | 2003275086 A1 | 23-04-2004 |
| | | | CN | 1701613 A | 23-11-2005 |
| | | | EP | 1547394 A2 | 29-06-2005 |
| | | | JP | 2006501678 T | 12-01-2006 |
| | | | WO | 2004032188 A2 | 15-04-2004 |
| WO 03081670 | A1 | 02-10-2003 | AU | 2003212566 A1 | 08-10-2003 |
| | | | CN | 1643685 A | 20-07-2005 |
| | | | JP | 4421301 B2 | 24-02-2010 |
| | | | JP | 2005521312 T | 14-07-2005 |
| | | | US | 2005104679 A1 | 19-05-2005 |
| WO 03065569 | A2 | 07-08-2003 | AU | 2003205944 A1 | 02-09-2003 |
| | | | CN | 1625834 A | 08-06-2005 |
| | | | JP | 2005516515 T | 02-06-2005 |
| | | | US | 2005083723 A1 | 21-04-2005 |
| WO 2006016299 | A1 | 16-02-2006 | NONE | | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020109203 A